Europäisches Patentamt

European Patent Office

Office européen des brevets

(19)

(11) Veröffentlichungsnummer: **0 308 709**

**A1**

(12) **EUROPÄISCHE PATENTANMELDUNG**

(21) Anmeldenummer: **88114400.0**

(22) Anmeldetag: **03.09.88**

(51) Int. Cl.⁴: **H03D 3/24**

(30) Priorität: **19.09.87 DE 3731567**

(43) Veröffentlichungstag der Anmeldung:
**29.03.89 Patentblatt 89/13**

(84) Benannte Vertragsstaaten:
**AT BE CH DE ES FR GB GR IT LI LU NL SE**

(71) Anmelder: **Deutsche Thomson-Brandt GmbH**
**Hermann-Schwer-Strasse 3 Postfach 1307**
**D-7730 Villingen-Schwenningen(DE)**

(72) Erfinder: **Pery, Antoine**
**Mannheimerstrasse 17**
**D-7730 Villingen-Schwenningen(DE)**
Erfinder: **Rufray, Jean-Claude**
**Hans Thoma Strasse 6**
**D-7734 Brigachtal(DE)**

(54) **Frequenzdemodulator in PLL-Technik.**

(57) Zur automatischen Einstellung der Ruhefrequenz $F_o$ eines Oszillators wird während bestimmter Zeiten eine Gleichspannung an den Eingang des Demodulators geschaltet. Bei einem idealen Demodulator entsteht an seinem Ausgang eine Gleichspannung, jedoch infolge eines immer vorhandenen Off-Sets des Demodulators erscheint während des Abgleichs immer ein Wechselspannungsanteil mit der Frequenz $F_o$. In jedem Fall unterscheidet sich das Ausgangssignal in der Frequenz von derjenigen des demodulierten Signals. Durch Gleichrichtereffekte nachfolgender Stufen ergibt sich eine Gleichspannung, die einen Fehlabgleich vortäuscht.

Um diesen Nachteil zu beseitigen, wird auf den Eingang (3) des Multiplizierers (4) während des Abgleichs die gleiche Frequenz gegeben wie im Demodulatorbetrieb, die jedoch um 90 Grad in der Phase gedreht ist. Dadurch ergibt sich immer am Ausgang ein Mittelwert Null.

Frequenzdemodulator z.B. für SECAM-Signale.

## Frequenzdemodulator in PLL-Technik

Die Erfindung betrifft einen Frequenzdemodulator in PLL-Technik mit einem spannungsgesteuerten Oszillator und einem Multiplizierer, dessen einem Eingang das modulierte Signal und dessen anderem Eingang das Oszillatorsignal zugeführt und an dessen Ausgang das demodulierte Signal entnehmbar ist, wobei der Signaleingang des Multiplizierers während des Ruhefrequenzabgleichs auf ein Referenzsignal umgeschaltet wird.

Ein solcher Frequenzdemodulator dient z.B. zur Demodulation von Farbfernsehsignalen der SECAM-Norm. Bei einem derartigen Frequenzdemodulator wird in bestimmten Zeitabständen, z.B. während des vertikalen Rücklaufs der Elektronenstrahlen in der Bildröhre eines Farbfernsehempfängers ein Gleichspannungssignal an den Signaleingang des Multiplizierers gelegt, um den Oszillator auf die Ruhefrequenz $F_0$ abzugleichen. An dem anderen Eingang des Multiplizierers liegt das konstante Ausgangssignal des Oszillators mit der Ruhefrequenz $F_0$. Während der Demodulation der frequenzmodulierten Eingangssignale liegen an beiden Eingängen des Multiplizierers Wechselspannungen der Frequenz $F_0$, von denen die eine mit der Frequenz $+/-$ Delta f moduliert ist. Am Ausgang des Multiplizierers entsteht dann ein Signal der Frequenz $2F_0$ mit einer Gleichspannungskomponente nach der Beziehung $\sin x * \sin(x + \phi) = 0.5 \cos\phi - 0.5 * \cos(2x + \phi)$. Bei der automatischen Einstellung des Oszillators auf die Ruhefrequenz $F_0$ wird an den Signaleingang des Multiplizierers eine Gleichspannung gelegt. Im Fall eines idealen Multiplizierers liefert dieser an seinen Ausgang keine Wechselspannung. Da der reale Multiplizierer jedoch immer einen Off-Set besitzt, entsteht während des Abgleichs am Ausgang des Multiplizierers immer eine wenn auch geringe Wechselspannungskomponente der Frequenz $F_0$. Diese Frequenz unterscheidet sich aber von der Frequenz, die bei der Demodulation am Ausgang entsteht, nämlich $2F_0$. Das bedeutet, daß in jedem Fall, ob es sich nun um einen idealen Demodulator ohne jeglichen Off-set oder um einen realen Demodulator mit Off-set handelt, am Ausgang ein Signal mit einer Frequenz entsteht, die nicht mit der Frequenz $2F_0$ des demodulierten Signals übereinstimmt. Die Schaltungen, die sich an den Demodulator anschließen, reagieren auf grund von Gleichrichtereffekten unterschiedlich auf diese Frequenzen 0, $F_0$, und $2F_0$ so daß sie auf einen angeblichen Fehlabgleich reagieren, obwohl die Ruhefrequenz $F_0$ genau eingestellt ist.

Der Erfindung liegt die Aufgabe zugrunde, diesen Nachteil zu beseitigen. Diese Aufgabe wird durch die im Patentanspruch angegebene Erfindung gelöst.

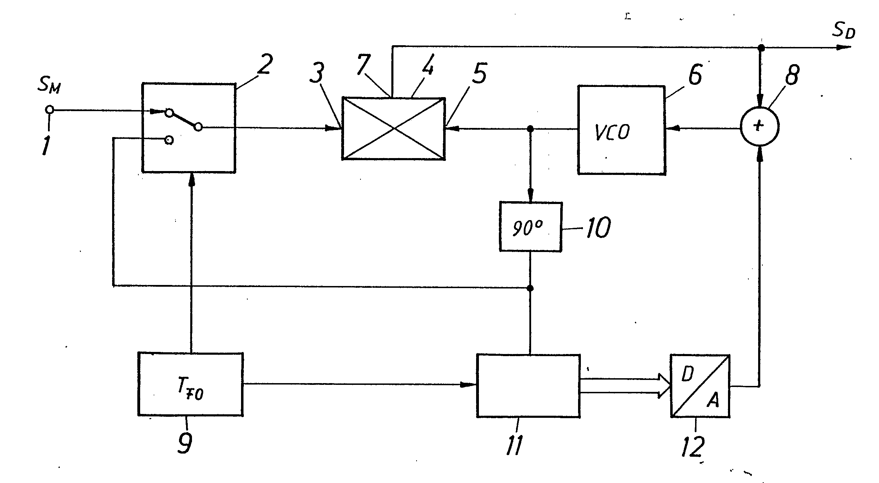

Nachstehend wird die Erfindung an einem Ausführungsbeispiel mit Hilfe der Zeichnung erläutert.

Über den Eingang 1 wird das frequenzmodulierte Signal $S_M$ über einen Umschalter 2 an den einen Eingang 3 eines Multiplizierers 4 gelegt, an dessen anderem Eingang 5 das von einem Oszillator 6 erzeugte Signal liegt. Am Ausgang 7 des Multiplizierers 4 entsteht dann das demodulierte Signal $S_D$. Das Signal $S_D$ wird als Steuerspannung dem Oszillator 6 über eine Addierstufe 8 zugeführt.

Zur automatischen Einstellung der Ruhefrequenz $F_0$ des Oszillators 6 wird z.B. jeweils während der Vertikalrücklaufzeit $T_{FO}$ der Schalter 2 durch eine Steuerschaltung 9 umgeschaltet. Zur Vermeidung der eingangs der Beschreibung auftretenden Nachteile wird über diesen Schalter 2 dem Eingang 3 des Multiplizierers 4 eine in einem Phasendrehglied 10 um 90 Grad gedrehte Komponente des Oszillatorsignals zugeführt. Dadurch liegt am Eingang des Multiplizierers 4 die gleiche Frequenz an wie im Demodulationsbetrieb. Durch die 90 Grad Phasenverschiebung entsteht am Ausgang eine Wechselspannung der Frequenz $2F_0$ mit dem Mittelwert Null. Die Frequenz der um 90 Grad gedrehten Ausgangsspannung des Oszillators 6 wird während der Zeit $T_{FO}$ des Abgleichs mit Hilfe eines Frequenzmessers 11 festgestellt, derem Wert in einem Digital-Analog-Wandler 12 in eine Gleichspannung umgewandelt wird, die über die Addierstufe 8 zur Regelung des Oszillators 6 dient.

## Ansprüche

1. Frequenzdemodulator in PLL-Technik mit einem spannungsgesteuerten Oszillator und einem Multiplizierer, dessen einem Eingang das modulierte Signal und an dessen anderem Eingang das Oszillatorsignal zugeführt und dessem Ausgang das demodulierte Signal entnehmbar ist, wobei der Signaleingang des Multiplizierers während des Ruhefrequenzabgleichs auf ein Referenzsignal umgeschaltet wird, **dadurch gekennzeichnet,** daß während der automatischen Ruhefrequenzeinstellung das Oszillatorsignal des spannungsgesteuerten Oszillators (6) dem einen Eingang des Multiplizierers (4) direkt und dem anderen Eingangdes Multiplizierers (4) über ein Phasendrehglied (10) zugeführt wird.

2. Frequenzdemodulator nach Anspruch 1, **dadurch gekennzeichnet,** daß die Phasendrehung des Phasendrehgliedes (10) einen Wert von 90 Grad besitzt.

EP 0 308 709 A1

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
| --- | --- | --- | --- |
| X | EP-A-0 099 814 (THOMSON-CSF) * Figur 1; Seite 4, Zeile 16 - Seite 6, Zeile 12 * --- | 1,2 | H 03 D 3/24 |
| A | PATENT ABSTRACTS OF JAPAN, Band 5, Nr. 3 (E-40)[675], 10. Januar 1981, Seite 107 E40; & JP-A-55 134 541 (FUJITSU K.K.) 20-10-1980 * Figur; Zusammenfassung * --- | 1 | |
| A | US-A-3 903 482 (PAUSINI et al.) * Figur 1; Zusammenfassung * --- | 1 | |
| A | DE-A-3 243 014 (DEUTSCHE THOMSON/BRANDT) ----- | | |

| | |
| --- | --- |
| | RECHERCHIERTE SACHGEBIETE (Int. Cl.4) |
| | H 03 D H 03 L |

Der vorliegende Recherchenbericht wurde für alle Patentansprüche erstellt

| Recherchenort | Abschlußdatum der Recherche | Prüfer |
| --- | --- | --- |
| DEN HAAG | 14-12-1988 | PEETERS M.M.G. |